# EUROPÄISCHE PATENTANMELDUNG

(11) **EP 2 169 315 A2**
(43) Veröffentlichungstag der Anmeldung: **31.03.2010**
(21) Anmeldenummer: 09011243.4
(22) Anmeldetag: 02.09.2009
(51) Int. Cl.: F24C 7/08

(54) **Bedienblende für ein Haushaltsgerät**

(30) Priorität: 26.09.2008 DE 102008049176
(71) Anmelder: Diehl AKO Stiftung & Co. KG, 88239 Wangen im Allgäu (DE)
(72) Erfinder: Kaps, Werner, 88171 Weiler-Simmerberg (DE); Frommelt, Thomas, 81243 München (DE)
(74) Vertreter: Diehl Patentabteilung

(57) **Zusammenfassung**

Eine Bedienblende für ein Haushaltsgerät hat einen Blendenkörper (13), der eine dem Benutzer zugewandte Bedienseite (13a) und eine dieser Bedienseite abgewandte Rückseite (13b) aufweist. Auf der Rückseite (13b) des Blendenkörpers (13) sind ein Sensorelement (10) aus einem elektrisch leitfähigen Material, welches zusammen mit dem Blendenkörper (13) ein kapazitives Sensorfeld bildet, und eine Konvertierungselektronik (16) zum Konvertieren der am Sensorfeld erzeugten Kapazitätswerte in digitale Signale, welche mit dem Sensorelement (10) elektrisch leitend verbunden ist, angeordnet, wobei das Sensorelement (10) und die Konvertierungselektronik (16) fest mit dem Blendenkörper (13) verbunden sind und zwei von einer Steuerelektronik (20) des Haushaltsgeräts mechanisch entkoppelte Komponenten sind.

## Beschreibung

Die Erfindung betrifft Bedienblenden für Haushaltsgeräte, insbesondere Bedienblenden mit kapazitiven Berührungsschaltern.

Häufig werden in elektrischen Geräten, insbesondere in Haushaltsgeräten wie Herden, Kochfeldern, Mikrowellenöfen, Spülmaschinen, Waschmaschinen und dergleichen, Berührungsschalter eingesetzt. Diese lösen durch einfaches Berühren durch einen Benutzer oder einen Gegenstand einen bestimmten Schaltvorgang aus. Im Fall eines kapazitiven Berührungsschalters bildet ein kapazitives Sensorelement zusammen mit dem Finger des Benutzers über ein als Dielektrikum wirkendes Berührungsfeld eine Kapazität. Diese ist entsprechend dem Betätigen des Berührungsschalters, d.h. dem Berühren oder Nichtberühren eines dem kapazitiven Sensorelement zugeordneten Berührungsfeldes, variabel. Die Veränderung der Kapazität des kapazitiven Sensorelements durch die Berührung wirkt sich auf ein Ausgangssignal der Sensorschaltung aus, was von einer angeschlossenen Auswerteschaltung als eine Betätigung des kapazitiven Berührungsschalters ausgewertet wird. Kapazitive Berührungsschalter sind beispielsweise aus der DE 32 45 803 A1 bekannt.

Um einen solchen kapazitiven Sensor oder Schalter zu erhalten, werden beispielsweise federnde Funktionselemente direkt auf der Gerätesteuerelektronik platziert. Die zur Konvertierung des kapazitiven Signals notwendigen elektrischen Bauelemente sitzen dabei unmittelbar unter dem Annäherungsschalter. Die über diesen Funktionselementen liegende Bedienblende bildet hier eine Aufnahme und damit eine Fixierung der Steuerelektronik sowie das Designelement. Die Form des Bedienfeldes ist unmittelbar an die Gerätesteuerelektronik gekoppelt. Jede Änderung in der Form des Bedienfelds, d.h. im Design, erfordert damit auch eine Änderung bzw. Anpassung der Steuerelektronik. Eine derartige Anordnung des Sensorelements und Verbindung des Sensorelements mit der Steuerelektronik sind zum Beispiel in der DE 201 19 700 U1 offenbart; in diesem Fall wird das kapazitive Sensorelement auf die Rückseite des Blendenkörpers aufgedruckt.

Es ist eine Aufgabe der vorliegenden Erfindung, eine Bedienblende für Haushaltsgeräte mit Berührungsschaltern bereitzustellen, die eine größere Flexibilität in der Produktion ermöglicht.

Diese Aufgabe wird durch eine Bedienblende für ein Haushaltsgerät mit den Merkmalen des Anspruchs 1 gelöst. Vorteilhafte Ausgestaltungen und Weiterbildungen der Erfindung sind Gegenstand der abhängigen Ansprüche.

Die erfindungsgemäße Bedienblende für ein Haushaltsgerät hat einen Blendenkörper, der eine dem Benutzer zugewandte Bedienseite und eine dieser Bedienseite abgewandte Rückseite aufweist. Auf der Rückseite des Blendenkörpers sind ein Sensorelement aus einem elektrisch leitfähigen Material, welches zusammen mit dem Blendenkörper ein kapazitives Sensorfeld bildet, und eine Konvertierungselektronik zum Konvertieren der am Sensorfeld erzeugten Kapazitätswerte in digitale Signale, welche mit dem Sensorelement elektrisch leitend verbunden ist, angeordnet. Dabei sind das Sensorelement und die Konvertierungselektronik fest mit dem Blendenkörper verbunden. Außerdem sind das Sensorelement und die Konvertierungselektronik zwei von der Steuerelektronik des Haushaltsgeräts mechanisch entkoppelte Komponenten.

Erfindungsgemäß sind das Sensorelement und die Konvertierungselektronik fest mit der Rückseite des Blendenkörpers verbunden. Die mit dem Sensorelement verbundene Konvertierungselektronik bietet alle für die verschiedenen Designs notwendigen Ausgangssignale für die weitere Verarbeitung der verschiedensten Anwendungsbereiche der Hausgeräteindustrie. Mit der (mechanischen) Entkoppelung der kapazitiven Sensoren inklusive Konvertierungselektronik von der Gerätesteuerelektronik können schnell die unterschiedlichsten Konfigurationen, Designs und Funktionselemente umgestellt und ausgeführt werden. Über die Programmierung und Parametrierung der Konvertierungselektronik erfolgt dann die jeweilige Anpassung an das vorliegende Design.

Durch die Abkoppelung der Design- und Funktionselemente von der eigentlichen Gerätesteuerelektronik kann hochflexibel auf unterschiedliche Kundenwünsche eingegangen werden. Gleichzeitig ergibt sich für die Steuerelektronik eine Reduzierung der Leiterplattengrößen mit den damit verbundenen Kosteneinsparungen sowohl im Materialeinsatz wie auch in der Produktionstechnik.

In einer bevorzugten Ausführungsform der Erfindung ist das Sensorelement in seiner Umfangsrichtung von einem Abschirmelement umgeben, welches fest mit dem Blendenkörper verbunden ist. Das Abschirmelement umfasst zum Beispiel eine mit der Bedienblende verbundene Abschirmschicht aus einem elektrisch leitfähigen Material und eine Isolationsschicht aus einem elektrisch isolierenden Material, welche die Abschirmschicht im Wesentlichen vollständig umschließt.

In einer weiteren Ausgestaltung der Erfindung sind das Sensorelement und/oder das Abschirmelement vorzugsweise auf die Rückseite des Blendenkörpers aufgedruckt. Sensorelement und Abschirmelement (d.h. Abschirmschicht und Isolationsschicht) werden vorzugsweise durch Aufdrucken eines elektrisch leitfähigen bzw. eines elektrisch nicht leitenden Lackes durch herkömmliche Techniken der Drucktechnik auf die Rückseite des Blendenkörpers aufgedruckt. Beispielsweise kann als Drucktechnik das bekannte Tampondruckverfahren verwendet werden. Das Siebdruckverfahren ist ebenfalls einsetzbar.

Elektrisch nicht-leitende Lacke, so genannte Isolierlacke, wie auch elektrisch leitfähige Lacke, sind aus dem Stand der Technik bekannt und kommerziell erhältlich.

In einer Ausgestaltung der Erfindung sind das Sensorelement und die Konvertierungselektronik über ein Verbindungselement aus einem elektrisch leitfähigen Material miteinander verbunden. Beispielsweise ist das Verbindungselement aus einer elektrisch leitfähigen Folie und/oder einer elektrisch leitfähigen Paste, wie zum Beispiel einer elektrisch leitfähigen Klebeschicht gebildet. Elektrisch leitfähige Kleber sind aus dem Stand der Technik bekannt und kommerziell erhältlich

In einer noch weiteren Ausgestaltung der Erfindung ist ferner eine Haltevorrichtung zum Drücken der Konvertierungselektronik und des Sensorelements gegeneinander vorgesehen.

Natürlich können an einer Bedienblende mehrere Sensorelemente auf der Rückseite des Blendenkörpers angeordnet sein.

In einer weiteren Ausgestaltung der Erfindung ist die Konvertierungselektronik über eine Kabelverbindung, welche vorzugsweise durch ein flexibles Kabel gebildet ist, elektrisch mit der Steuerelektronik des Haushaltsgeräts verbunden.

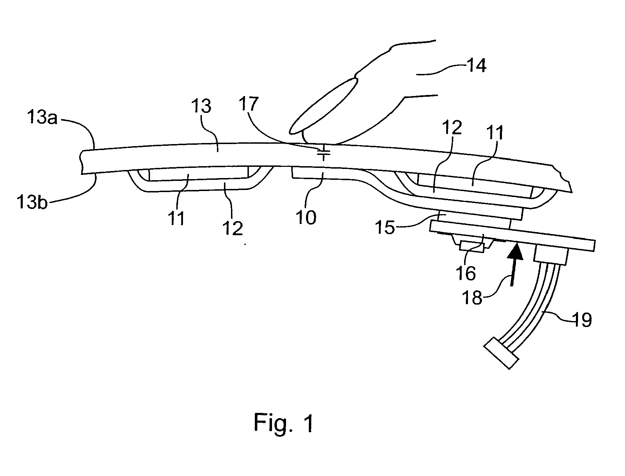

Obige sowie weitere Merkmale und Vorteile der Erfindung werden aus der nachfolgenden Beschreibung eines bevorzugten, nicht einschränkenden Ausführungsbeispiels unter Bezug auf die beiliegenden Zeichnungen besser verständlich. Darin zeigt die einzige Figur 1 eine schematische Teilschnittansicht einer Bedienblende gemäß der vorliegenden Erfindung.

Die Bedienblende für Haushaltsgeräte bildet eine Funktionsgruppe mit einem kapazitiven Touchsensorfeld sowie zugehöriger Konvertierungselektronik. Diese Funktionsgruppe ist auf der Rückseite des Blendenkörpers einer Bedienblende angeordnet und fest, d.h. dauerhaft mit dieser verbunden. Die an der Bedienblende angebrachten elektronischen Komponenten (Sensorelemente, Konvertierungselektronik) sind von der (zentralen) Steuerelektronik des Haushaltsgeräts mechanisch entkoppelt, sodass die Steuerelektronik grundsätzlich unabhängig vom Design der Bedienblende konzipiert und für die Produktion vorgehalten werden kann.

Wie in Fig. 1 dargestellt, hat die Bedienblende einen Blendenkörper 13 mit einer dem Benutzer zugewandten Bedienseite 13a (oben in Fig. 1) und einer der Benutzerseite abgewandten Rückseite 13b (unten in Fig. 1). Der Blendenkörper 13 kann wahlweise leicht gekrümmt sein, wie in Fig. 1 gezeigt, oder im Wesentlichen eben gestaltet sein.

Die Bedienblende ist mit mehreren kapazitiven Berührungsschaltern ausgestaltet, die jeweils ein Sensorfeld aufweisen, wobei in Fig. 1 beispielhaft nur ein solches Sensorfeld veranschaulicht ist. Das Sensorfeld wird durch ein auf der Rückseite 13b des Blendenkörpers 13 angeordnetes Sensorelement 10 aus einem elektrisch leitfähigen Material gebildet, welches fest, d.h. dauerhaft mit dem Blendenkörper 13 verbunden ist. Das Sensorelement 10 besteht vorzugsweise aus einem elektrisch leitfähigen Material mit einem möglichst niedrigen elektrischen Leitungswiderstand.

Das Sensorelement 10 und damit das Sensorfeld kann entsprechend den gewünschten Funktionen jede beliebige geometrische Konfiguration annehmen, die dem Design der Bedienblende folgt. Dabei spiegelt das Sensorelement 10 auf der Rückseite 13b des Blendenkörpers 13 nur die räumliche Anordnung der Designelemente wider; es bleibt aber eine rein kapazitive Funktionsfläche. Auf diese Weise können voneinander unabhängige Sensorfelder erzeugt werden, die über eine kapazitive Kopplung mit z.B. einem oder auch mehreren Fingern 14 oder eines oder mehrerer anderer Gegenstände einen oder mehrere kapazitive Werte erzeugen.

Um eine von der Vorderseite 13a des Blendenkörpers 13 her z.B. durch einen Finger 14 angebrachte Kapazität 17 nur auf den für die Funktion notwendigen Bereich zu konzentrieren, ist das Sensorelement 10 auf der Rückseite 13b des Blendenkörpers 13 entlang seines Umfanges von einem Abschirmelement umgeben, welches ebenfalls fest mit dem Blendenkörper 13 verbunden ist. Dieses Abschirmelement ist aus einer Abschirmschicht 11 aus einem elektrisch leitfähigen Material, die mit der Rückseite 13b des Blendenkörpers 13 verbunden ist, und einer Isolationsschicht 12 aus einem elektrisch isolierenden Material, die die Abschirmschicht 11 im Wesentlichen vollständig einschließt, gebildet.

Wie in Fig. 1 veranschaulicht, erstreckt sich das Sensorelement 10 über das eigentliche Sensorfeld der Bedienblende hinaus bis über das Abschirmelement 11, 12. Dort ist das Sensorelement 10 über ein Verbindungselement 15 aus einem - zumindest in seiner Dickenrichtung (Oben/Unten-Richtung in Fig. 1) - elektrisch leitfähigem Material wie zum Beispiel einem Leitkleber in Form einer elektrisch leitfähigen Folie und/oder Paste mit einer Konvertierungselektronik 16 verbunden.

Die Konvertierungselektronik 16 konvertiert die am Sensorelement 10 erzeugten Kapazitätswerte in digitale Signale und überträgt diese digitalen Signale zum Beispiel über eine (im Allgemeinen flexible) Kabelverbindung 19 an eine zentrale Steuerung bzw. Steuerelektronik 20 des jeweiligen Haushaltsgeräts.

Die Konvertierungselektronik 16 ist zum Beispiel auf einer Leiterplatte aufgebaut und trägt im Wesentlichen den Baustein (z.B. CD-Wandler), der für die Umwandlung der kapazitiven Werte, welche bei der Berührung der Blendenoberseite 13a durch das Sensorelement 10 auf der Blendenunterseite 13a erzeugt werden, in digitale Signale erforderlich ist. Ferner sind auf der Leiterplatte der Konvertierungselektronik 16 weitere schaltungstechnisch notwendige Bauteile vorhanden, ohne die der CD-Wandler nicht arbeiten kann. Die elektrische Verbindung mit der Steuerelektronik 20 (zur Datenübertragung an die Steuerelektronik 20 und zur Stromversorgung der Konvertierungselektronik 16) erfolgt über die Kabelverbindung 19.

Die Steuerelektronik 20 des Haushaltsgeräts übernimmt die von der Konvertierungselektronik 16 gesendeten digitalen Signale und verarbeitet diese weiter. So steuert die Steuerelektronik 20 die unterschiedlichen für das Haushaltsgerät (z.B. Waschmaschine) notwendigen Funktionen (z.B. Waschprogramm, Schleuderdrehzahl, Abpumpfunktion, usw.). Die Steuerelektronik 16 bildet damit die Verbindung zu den so genannten Hardware-Komponenten des Haushaltsgeräts. Zusätzlich beinhaltet die Steuerelektronik auch die für die Funktionen notwendigen Auswahlmöglichkeiten über die in ihr integrierte Software.

Die Konvertierungselektronik 16 ist ebenfalls fest, d.h. dauerhaft mit dem Blendenkörper 13 der Bedienblende verbunden. Um einen sicheren elektrischen Kontakt zwischen dem Sensorelement 10 und der Konvertierungselektronik 16 zu gewährleisten, wird mit Hilfe einer entsprechenden Haltevorrichtung 18 eine permanente Andruckkraft 18a ausgeübt, die die Konvertierungselektronik 16 gegen das Verbindungselement 15 und das Sensorelement 10 drückt. Hierdurch wird gesichert, dass das System weder durch thermische noch durch mechanische Einflüsse und Belastungen elektrisch außer Funktion gerät.

Sind an der Bedienblende 13 mehrere Sensorelemente 10 vorgesehen, so sind diese vorzugsweise mit einer gemeinsamen Konvertierungselektronik 16 gekoppelt. Wahlweise können aber auch einzelne Gruppen von Sensorelementen 10 oder einzelne Sensorelemente 10 jeweils mit einer von mehreren Konvertierungselektroniken 16 verbunden sein.

Zur Herstellung der oben beschriebenen Funktionsgruppe werden das Abschirmelement 11, 12 und das Sensorelement 10 vorzugsweise nacheinander auf die Rückseite 13b des Blendenkörpers 13 aufgedruckt. Die Abschirmschicht 11 als erste Schicht des Gesamtsystems deckt vorzugsweise alle nicht unmittelbar für die spätere Funktion notwendigen leitfähigen Bereiche hinreichend ab. Sie ist dem jeweils zur Anwendung kommenden Design des Sensorfeldes angepasst.

Danach erfolgt ein zweiter Druckvorgang, in dem die Isolationsschicht 12 aufgedruckt wird. Die Isolationsschicht 12 muss so ausgebildet sein, dass die für die spätere Funktion der Sensorfläche bzw. der Sensorflächen notwendigen Bereiche ausgespart bleiben, aber die zuvor aufgebrachte Abschirmschicht 11 möglichst vollständig überdeckt wird. Damit wird gewährleistet, dass keine elektrische Verbindung zwischen der Abschirmschicht 11 und dem eigentlichen Sensorfeld existiert.

Als abschließender Druckschritt wird dann das dem Design entsprechende Sensorelement 10 zum Ausbilden des kapazitiven Sensorfeldes auf die Rückseite 13b des Blendenkörpers 13 aufgedruckt. Durch das Aufdrucken "schmiegt" sich das Sensorelement 10 an den Blendenkörper 13 an. Dies hat den Vorteil, dass eine luftspaltfreie Verbindung mit dem Blendenkörper gebildet wird. Dies minimiert Störungen bei der Bedienung, da eine Berührung der Bedienblende von der Vorderseite 13a her durch das Sensorelement 10 unmittelbar registriert wird.

Anschließend werden das Verbindungselement 15 und die Konvertierungselektronik 16 angebracht. Das Verbindungselement (Folie, Paste, Kleber) 15 wird mittels einer üblichen Einrichtung in den Bereich der Kontaktierung des Sensorelements 10 appliziert.

### BEZUGSZIFFERNLISTE

- 10: Sensorelement
- 11: Abschirmschicht
- 12: Isolationsschicht
- 13: Blendenkörper
- 13a: Bedienseite
- 13b: Rückseite
- 14: Finger
- 15: Verbindungselement
- 16: Konvertierungselektronik
- 17: Kapazität
- 18: Haltevorrichtung
- 18a: Andruckkraft
- 19: Kabelverbindung
- 20: Steuerelektronik

## Patentansprüche

1. Bedienblende für ein Haushaltsgerät, mit einem Blendenkörper (13), der eine dem Benutzer zugewandte Bedienseite (13a) und eine dieser Bedienseite abgewandte Rückseite (13b) aufweist, und einem auf der Rückseite (13b) des Blendenkörpers (13) angeordneten und fest mit diesem verbundenen Sensorelement (10) aus einem elektrisch leitfähigen Material, welches zusammen mit dem Blendenkörper (13) ein kapazitives Sensorfeld bildet,
**dadurch gekennzeichnet,**
**dass** auf der Rückseite (13b) des Blendenkörpers (13) eine Konvertierungselektronik (16) zum Konvertieren der am Sensorfeld erzeugten Kapazitätswerte in digitale Signale angeordnet ist, welche fest mit dem Blendenkörper (13) verbunden ist und mit dem Sensorelement (10) elektrisch leitend verbunden ist, wobei das Sensorelement (10) und die Konvertierungselektronik (16) zwei von einer Steuerelektronik (20) des Haushaltsgeräts mechanisch entkoppelte Komponenten sind.

2. Bedienblende nach Anspruch 1,
**dadurch gekennzeichnet,**
**dass** das Sensorelement (10) in seiner Umfangsrichtung von einem Abschirmelement (11, 12) umgeben ist, welches fest mit dem Blendenkörper (13) verbunden ist.

3. Bedienblende nach Anspruch 2,
**dadurch gekennzeichnet,**
**dass** das Abschirmelement (11, 12) eine mit der Bedienblende (13) verbundene Abschirmschicht (11) aus einem elektrisch leitfähigen Material und eine Isolationsschicht (12) aus einem elektrisch isolierenden Material, welche die Abschirmschicht (11) im Wesentlichen vollständig umschließt, umfasst.

4. Bedienblende nach einem der vorhergehenden Ansprüche,
**dadurch gekennzeichnet,**
**dass** das Sensorelement (10) auf die Rückseite (13b) des Blendenkörpers (13) aufgedruckt ist.

5. Bedienblende nach einem der Ansprüche 2 bis 4,
**dadurch gekennzeichnet,**
**dass** das Abschirmelement (11, 12) auf die Rückseite (13b) des Blendenkörpers (13) aufgedruckt ist.

6. Bedienblende nach einem der vorhergehenden Ansprüche,
**dadurch gekennzeichnet,**
**dass** das Sensorelement (10) und die Konvertierungselektronik (16) über ein Verbindungselement (15) aus einem elektrisch leitfähigen Material miteinander verbunden sind.

7. Bedienblende nach einem der vorhergehenden Ansprüche,
**dadurch gekennzeichnet,**
**dass** eine Haltevorrichtung (18) zum Drücken (18a) der Konvertierungselektronik (16) und des Sensorelements (10) gegeneinander vorgesehen ist.

8. Bedienblende nach einem der vorhergehenden Ansprüche,
**dadurch gekennzeichnet,**
**dass** mehrere Sensorelemente (10) auf der Rückseite (13b) des Blendenkörpers (13) angeordnet sind.

9. Bedienblende nach einem der vorhergehenden Ansprüche,
**dadurch gekennzeichnet,**
**dass** die Konvertierungselektronik (16) über eine Kabelverbindung (19) elektrisch mit der Steuerelektronik (20) des Haushaltsgeräts verbunden ist.
